# EUROPEAN PATENT APPLICATION

(11) **EP 1 028 328 A2**
(43) Date of publication of application: **16.08.2000**
(21) Application number: 00300709.3
(22) Date of filing: 31.01.2000
(51) Int. Cl.: G02B 6/12, G02B 5/20

(54) **Process for fabricating article exhibiting substantial three-dimensional order and resultant article**

(30) Priority: 11.02.1999 US 248577
(71) Applicant: LUCENT TECHNOLOGIES INC., Murray Hill, New Jersey 07974-0636 (US)
(72) Inventor: Van Nest Braun, Paul, Berkeley Heights, New Jersey 07922 (US); Patel, Sanjay, New Providence, New Jersey 07974 (US); Wiltzius, Pierre, Millington, New Jersey 07946 (US)
(74) Representative: Johnston, Kenneth Graham

(57) **Abstract**

A structure exhibiting substantial periodicity on a micron scale, e.g., a photonic band gap material, is provided. The structure is fabricated by a process involving the steps of providing a template comprising a colloidal crystal, and introducing into the colloidal crystal a liquid dispersion of nanoparticles. The resulting composite is treated, e.g., dried, to form a cohesive structure from the nanoparticles, and the colloidal crystal particles are removed to form the ordered structure.

## Description

### BACKGROUND OF THE INVENTION

### Field of the Invention

The invention relates to structures exhibiting three-dimensional periodicity, for example structures useful for photonic applications.

### Discussion of the Related Art

Recently, there has been increasing interest in periodic dielectric structures, also referred to as photonic crystals (PC), in particular, photonic crystals exhibiting gaps in photonic band structures (referred to as photonic band gap (PBG) materials), for numerous photonic applications. See, e.g., P.S.J. Russell, "Photonic Band Gaps," Physics World, 37, August 1992; I. Amato, "Designing Crystals That Say No to Photons," Science, Vol. 255, 1512 (1993); and U.S. Patents Nos. 5,600,483 and 5,172,267, the disclosures of which are hereby incorporated by reference. PBG materials exhibit a photonic band gap, analogous to a semiconductor's electronic band gap, that suppress propagation of certain frequencies of light, thereby offering, for example, photon localization or inhibition of spontaneous emissions. A PC is generally formed by providing a high refractive index dielectric material with a three-dimensional lattice of cavities or voids having low refractive index. Photons entering the material concentrate either at the high-index regions or the low-index regions, depending on the particular energy of the photon, and the photonic band gap exists for photons of a particular energy between the two regions. Photons having energy within the PBG cannot propagate through the material, and their wave function thereby decays upon entering the material. The photonic band structure, therefore, depends on the precision of the physical structure and on its refractive index, and some difficulty has arisen in fabricating such materials. Specifically, it has been difficult to organize a three-dimensional lattice of micron scale, particularly with high refractive index materials.

In one approach, reflected in the above-cited U.S. Patents, solid materials are provided with numerous holes by mechanical techniques, e.g., drilling, or lithographic techniques, e.g., etching. This approach has provided useful results, but is limited by the ability of current processing technology to provide the necessary structure.

In another approach, ordered colloidal suspensions or sediments of relative low refractive index particles such as polystyrene, referred to as colloidal crystals, are used as templates for infiltration or deposition of high refractive index materials in a desired structure, and the particles are then etched away or burned out to provide the voids. See, e.g., B.T. Holland et al., "Synthesis of Macroporous Minerals with Highly Ordered Three-Dimensional Arrays of Spheroidal Voids," Science, Vol. 281, 538 (July 1998); E.G. Judith et al., "Preparation of Photonic Crystals Made of Air Spheres in Titania," Science, Vol. 281, 802 (July 1998); and A.A. Zakhidov et al., "Carbon Structures with Three-Dimensional Periodicity at Optical Wavelengths," Science, Vol. 282, 897 (October 1998). The infiltration/deposition has been performed, for example, by an alkoxide sol-gel technique and by chemical vapor deposition. The results attained thus far have been interesting, but are far from providing a commercially feasible product. Specifically, the infiltration/deposition of the high refractive index material tends to be insufficient (e.g., low density leading to low refractive index) and non-uniform. For example, during alkoxide sol-gel deposition and CVD, some voids near the outside of the crystal become clogged, such that gelation/deposition at interior voids is inhibited. Moreover, insufficient and inadequate infiltration create voids within the high index material, causing substantial shrinkage, and thus cracking, during removal of the template material.

Thus, improved processes for fabrication of high density, substantially uniform photonic bandgap materials are desired.

### SUMMARY OF THE INVENTION

The process of the invention provides a structure, e.g., a photonic band gap material, exhibiting substantial periodicity on a micron scale, the process providing improved density and mechanical integrity compared to current processes. (Periodicity, as used herein indicates that the structure is composed of a three-dimensional periodic array of repeated units. See, e.g., N.W. Ashcroft et al., Solid State Physics, 64, W.B. Saunders Co. (1976).) The process involves the steps of providing a template comprising a colloidal crystal, and introducing into the colloidal crystal a liquid dispersion of nanoparticles. The resulting composite is treated, e.g., dried, to form a cohesive structure from the nanoparticles, and the colloidal crystal particles are then removed, e.g., by heating, etching, or dissolving. The nanoparticles have an average diameter ranging from about 1 nm to about 30% of the average diameter of the colloidal crystal particles, advantageously 1 nm to about 10% of the average diameter of the colloidal crystal particles. This small size enables the nanoparticles to readily infiltrate the crystal, providing a substantially uniform, high-density structure. Moreover, the small size of the nanoparticles also reduces void formation during introduction into the system, such that subsequent treatment to remove the colloidal crystal, and/or consolidate the infused material, induces only a small amount of shrinkage. Cracking is thereby lessened or avoided. Examples of suitable nanoparticles include, but are not limited to, titania, silicon, germanium, and gallium phosphide.

### BRIEF DESCRIPTION OF THE DRAWINGS

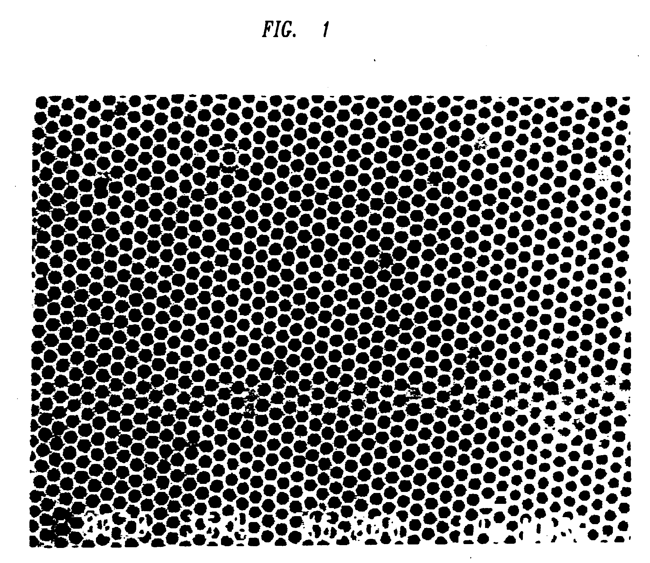

Fig. 1 is a scanning electron micrograph of an ordered titania lattice formed according to the invention.

### DETAILED DESCRIPTION OF THE INVENTION

The process of the invention involves the steps of providing a template comprising a colloidal crystal, and disposing within the voids of the colloidal crystal a liquid dispersion of nanoparticles. The resulting composite is treated, e.g., dried, to form an interconnected, cohesive structure from the nanoparticles, and the colloidal crystal particles are typically removed, e.g., by heating, etching, or dissolving. The resultant structure is a lattice of nanoparticle material containing a periodic array of voids reflecting the crystal template.

Colloidal crystals are periodic structures typically formed from small particles suspended in solution. It is possible to form them by allowing slow sedimentation of substantially uniformly-sized particles in a liquid, such that the particles arrange themselves in a periodic manner. Other fabrication techniques are also possible. For photonic bandgap applications, the average particle diameter typically ranges from about 100 nm to about 5 µm. A variety of sizes are possible, however, depending on the desired structure and use of the final product and on the availability of nanoparticles sufficiently smaller than the spaces between the crystal particles. It is possible to form colloidal crystals from any suitable materials. Examples include polystyrene, polymethylmethacrylate, and silica. Polystyrene and other organics are easily removed after formation of the cohesive nanoparticle structure by heating. Silica particles are easily removed by acid etching, e.g., by HF.

The lattice structure of colloidal crystals generally exhibits two-dimensional periodicity, but not necessarily substantial three-dimensional periodicity. Specifically, sedimentation of the colloidal particles induces a random stacking with the close-packed planes perpendicular to gravity. Such a randomly-stacked structure does not exhibit substantial three-dimensional periodicity, because of the randomness in the gravity direction. It is possible that such materials will be suitable for some applications, e.g., filters and catalysts. However, for many PBG applications, it is desired to have materials exhibiting substantial three-dimensional periodicity. One way to do so is to use colloidal epitaxy to form the template crystal, as discussed in A. van Blaaderen et al., "Template-directed colloidal crystallization," Nature, Vol. 385, 321 (January 1997), the disclosure of which is hereby incorporated by reference. Colloidal epitaxy involves growing a colloidal crystal normal to an underlying pattern, e.g., a series of holes, reflecting a particular three-dimensionally ordered crystal, e.g., the (100) plane of a face-centered cubic (FCC) crystal. The holes order the first layer of settling colloidal particles in a manner that controls the further sedimentation.

The nanoparticles are dispersed in an aqueous or nonaqueous solution, with a loading that maintains sufficient fluidity to provided the desired infiltration. Examples of suitable nanoparticles include, but are not limited to, titania, silicon, germanium, and gallium phosphide. The nanoparticles have an average diameter ranging from about 1 nm to about 30% of the average diameter of the colloidal crystal particles, advantageously 1 nm to about 10% of the average diameter of the colloidal crystal particles. For photonic bandgap applications, the nanoparticles are generally formed from a material having a relatively high refractive index, e.g., about 2 or greater, as well as relatively low loss. Their small size enables the nanoparticles to readily infiltrate the crystal, providing a substantially uniform, high-density structure. Moreover, the small size of the particles reduces void formation during infiltration such that subsequent treatment to remove the colloidal crystal induces only a small amount of shrinkage. Cracking is thereby lessened or avoided. Suitable nanoparticles include, but are not limited to, titania, silicon, germanium, and gallium phosphide.

The nanoparticle dispersion is dispensed into the colloidal crystal by any suitable technique. One useful technique is solution casting, advantageously where the solvent exhibits good wetting of the colloidal crystal.

Generally, the resulting composite material is then treated, typically by drying, to form a cohesive, interconnected nanoparticle structure within the crystal lattice. Optionally, a binder is used to contribute to the cohesiveness of the nanoparticle structure, such as by filling remaining porosity. It is possible for the binder to be the same material as the nanoparticles or a different material. The binder is capable of being introduced either with the nanoparticle solution or by a separate step, e.g., by an additional infiltration step. The composite material is then typically treated to remove the colloidal crystal material. (In some applications the presence of the colloidal crystal material may be acceptable.) For example, in the case of organics, the composite is typically heated to burn out the organics, e.g., at a temperature of at least 250°C. Other techniques are also possible, such as irradiation or plasma-assisted etching of the organic material. In the case of inorganic materials, a suitable etchant is generally applied, e.g., exposure of silica to HF. It is possible that the step of removing the crystal will also contribute to the cohesiveness, or the further cohesiveness, of the nanoparticle structure.

The resulting lattice contains an interconnected structure or lattice of the nanoparticles with a periodic array of voids therein. The size of the voids depend on the particles of the colloidal crystal, as mentioned above. For photonic applications, the voids typically range from about 100 nm to about 5 µm, and the effective refractive index is advantageously greater than 2.

The ordered structure is useful for a variety of photonic applications, including optical filters, optical switches, waveguides, routers, laser cavities and other photonic bandgap applications. Particular design considerations for PBG materials are known in the art, as reflected for example in J.D. Joannopoulos et al., Photonic Crystals, Princeton University Press (1995), the disclosure of which is hereby incorporated by reference. Other applications include filters, catalysts, and biocompatible materials.

The invention will be further clarified by the following example, which is intended to be exemplary.

### Example

A polystyrene colloidal crystal was formed through sedimentation of a polystyrene latex from a methanol solution onto a glass substrate. Chemically-modified polystyrene spheres having grafted carboxylic acid polymer thereon, with diameters as small as 0.466 µm, and as large as about 1 micron were used to form the colloidal crystal. Each batch of the latex had a coefficient of size variation of less than 5% which allowed the latex particles to pack into a hexagonal close packed array.

Once the colloidal crystal was dried, a solution of 25 wt.% TiO₂ nanoparticles was formed in water with a small amount of tetramethylammonium hydroxide. The nanoparticles had an average diameter of about 30 nm as measured by dynamic light scattering and were formed by a conventional method, as described in S.D. Burnside, "Self-Organization of TiO₂ Nanoparticles in Thin Films," Chem. Mater., Vol. 10, 2419 (1998). The solution was cast onto the colloidal crystal by placing a drop on the crystal and allowing the drop to soak in. The solvent was allowed to dry, and the composite of TiO₂ and polystyrene spheres was placed in a tube furnace and heated in air to 500°C at 10°C/minute. This heat treatment burned out the polystyrene and any organic molecules remaining from the TiO₂ synthesis, leaving behind a TiO₂ structure which is a substantially exact negative of the polystyrene colloidal crystal, as shown in Fig. 1. As reflected in the Figure, a relatively dense structure is obtained, with very little cracking due to the low shrinkage of less than 5%.

Other embodiments of the invention will be apparent to those skilled in the art from consideration of the specification and practice of the invention disclosed herein.

## Claims

1. A process for fabricating an article comprising a material exhibiting substantial periodicity, the process comprising the steps of:
providing a template comprising a colloidal crystal;
introducing into the crystal a liquid dispersion of nanoparticles having an average diameter ranging from about 1 nm to about 30% of the average diameter of the colloidal crystal particles;
treating the resultant composite to form an interconnected structure from the nanoparticles; and
removing the colloidal crystal to form the material exhibiting substantial periodicity.

2. A process for fabricating an article comprising a material exhibiting substantial periodicity, the process comprising the steps of:
providing a template comprising a colloidal crystal;
introducing into the crystal a liquid dispersion of nanoparticles having an average diameter ranging from about 1 nm to about 30% of the average diameter of the colloidal crystal particles; and
treating the resultant composite to form an interconnected structure from the nanoparticles.

3. A process for fabricating an article comprising a material exhibiting substantial periodicity, the process comprising the steps of:
providing a template comprising a colloidal crystal; and
introducing into the crystal a liquid dispersion of nanoparticles having an average diameter ranging from about 1 nm to about 30% of the average diameter of the colloidal crystal particles.

4. An article comprising a material that comprises an interconnected lattice comprising nanoparticles, the lattice comprising a periodic array of voids, and the nanoparticles having an average diameter ranging from about 1 nm to about 30% of the average diameter of the voids.

5. The process of claim 1,2, or 3, or the article of claim 4, wherein the material exhibits a photonic bandgap.

6. The process of claim 1 or 2, or 3, wherein the particles of the colloidal crystal have an average diameter ranging from about 100 nm to about 5 µm.

7. The process of claim 1,2, or 3, wherein the nanoparticles have an average diameter ranging from about 1 nm to about 10% of the average diameter of the colloidal crystal particles.

8. The process of claim 1, 2 or 3, or the article of claim 4, wherein the nanoparticles are selected from titania, silicon, germanium, and gallium phosphide.

9. The process of claim 1, wherein the treating step comprises at least one of application of a binder, evaporation, and heating.

10. The process of claim 1, wherein the removal of the colloidal crystal is performed by heating to at least 250°C, and wherein the nanoparticle structure shrinks less than 5% during the heating.

11. The process of claim 1, further comprising the step of forming the colloidal crystal by colloidal epitaxy.

12. The process of claim 11, wherein the colloidal crystal exhibits a face-centered cubic structure.

13. The article of claim 4, wherein the interconnected lattice further comprises a binder, and/or wherein the lattice material exhibits a refractive index of at least 2.

14. The article of claim 4, wherein the article is one of a filter, a catalyst, and a biocompatible body.
